# EUROPÄISCHE PATENTSCHRIFT

(11) **EP 2 128 700 B1**
(45) Veröffentlichungstag und Bekanntmachung des Hinweises auf die Patenterteilung: **12.07.2017**
(21) Anmeldenummer: 09006796.8
(22) Anmeldetag: 20.05.2009
(51) Int. Cl.: G03F 7/20

(54) **Lithographiesystem und Verfahren zur Regelung eines Lithographiesystems**
Lithography system and method for regulating same
Système de lithographie et procédé de réglage d'un système de lithographie

(30) Priorität: 30.05.2008 DE 102008026077
(43) Veröffentlichungstag der Anmeldung: 02.12.2009
(73) Patentinhaber: Integrated Dynamics Engineering GmbH, 65479 Raunheim (DE)
(72) Erfinder: Heiland, Peter, 65479 Raunheim (DE)
(74) Vertreter: Kampfenkel, Klaus

(56) Entgegenhaltungen:
- EP-A- 1 220 012
- EP-A- 1 237 044
- EP-A- 1 321 823
- WO-A2-2006/128713

## Beschreibung

### Gebiet der Erfindung

Die Erfindung betrifft ein Lithographiesystem sowie ein Verfahren zur Regelung eines Lithographiesystems.

### Hintergrund der Erfindung

Lithographiesysteme, insbesondere zur Belichtung von Halbleiterwafern sind aus der Praxis bekannt. Typischerweise umfasst ein Lithographiesystem eine Belichtungseinheit, welche eine Mehrzahl von Linsen umfasst. Es kann sich dabei sowohl um optische Linsen, als auch um elektrostatische Linsen zur Verwendung in der Elektronen- oder Ionenstrahlen-Litographie handeln.

Die Linsen, welche auch als Linsen-Array Verwendung finden können, sind vorzugsweise in mehreren Freiheitsgraden positionierbar. Das Dokument EP 1 321 823 A2 zeigt ein Lithographiegerät, bei welchem ein optisches Element, dessen Position relativ zu einem Rahmen gemessen wird, mit einem Aktor verbunden ist. Der Aktor ist zwischen dem Rahmen und dem optischen Element angeordnet.

Mit zunehmender Miniaturisierung in der Halbleiterindustrie werden die Anforderungen an die Genauigkeit von Lithographiesystemen immer höher. Ein Lithographiesystem umfasst daher typischerweise eine schwingungsisolierte Lagerung, insbesondere kann die Belichtungseinheit nebst der Wafer-Transportvorrichtung auf Luftlagern gelagert sein.

Nachteilig hat sich in der Praxis gezeigt, dass die Linsen der Belichtungseinheit aufgrund ihrer beweglichen Aufhängung ein Feder-Masse-System bilden, welches in erhöhtem Maße zu Schwingungen neigt. Typischerweise liegen die Eigenfrequenzen dieses Feder-Masse-Systems zwischen 100 und 500 Hz.

Insbesondere eine Bewegung einzelner Linsen relativ zueinander führt zu einer verschlechterten Fokussierung des Strahls, wodurch letztendlich die Auflösung des Lithographiesystems verschlechtert wird.

Die Minimierung dieser Schwingungen ist bislang auch durch extrem niederfrequent abgestimmte Schwingungsisolationssysteme nur eingeschränkt gelungen.

Das Dokument WO 2006/128713 A2 zeigt ein Belichtungssystem, bei welcher positionierbare Spiegel vorhanden sind.

### Aufgabe der Erfindung

Der Erfindung liegt demgegenüber die Aufgabe zugrunde, die genannten Nachteile des Standes der Technik zumindest zu reduzieren.

Insbesondere sollen gemäß der Erfindung die von beweglich gelagerten Linsen in einer Belichtungseinheit verursachten Schwingungen reduziert werden.

Eine weitere Aufgabe der Erfindung ist es, die Strahlqualität eines Lithographiesystems zu verbessern.

### Zusammenfassung der Erfindung

Die Erfindung wird bereits durch ein Lithographiesystem nach Anspruch 1 sowie durch ein Verfahren zur Regelung eines Lithographiesystems nach Anspruch 7 gelöst.

Bevorzugte Ausführungsformen und Weiterbildungen der Erfindung sind den jeweiligen Unteransprüchen zu entnehmen.

Die Erfindung betrifft ein Lithographiesystem, welches insbesondere zur Belichtung von Halbleiterwafern ausgebildet ist. Das Lithographiesystem umfasst eine schwingungsisoliert gelagerte Belichtungseinheit, welche eine Optik mit einer Mehrzahl von positionierbaren Linsen umfasst. Unter einer Positionierbarkeit wird eine Beweglichkeit der Linsen, vorzugsweise in allen sechs Freiheitsgraden verstanden.

Es ist zumindest ein Sensor vorgesehen, über den die Position und/oder Beschleunigung zumindest der Linsen erfasst wird.

Über einen Beschleunigungs- oder Lagesensor können also Bewegungen, insbesondere Schwingungen der Linse zwischen 100 und 500 Hz erfasst werden und bei einer aktiven Regelung eines Schwingungsisolationssystems, welches Teil des Lithographiesystems im Sinne der Erfindung ist, verwendet werden.

Es versteht sich, dass unter einer Linse auch ein Array von Linsen verstanden wird, beziehungsweise dass der oder den Linsen eine Aufnahme zugeordnet sein kann, wobei die Beschleunigung oder Position der Linse anhand der Bewegung der Aufnahme ermittelt werden kann.

Die Linsen sind jeweils mit einem Aktor zur aktiven Schwingungsisolation gekoppelt.

Gemäß der Erfindung ist der Aktor vom Gehäuse der Belichtungseinheit entkoppelt.

Insbesondere kann der Aktor starr mit der Basis des Schwingungsisolationssystems gekoppelt sein, was den Vorteil hat, dass Eigenschwingungen des Gehäuses der Belichtungseinheit keinen Einfluss auf die Wirkung des Aktors haben.

Weiter kann der Aktor als aktiver Schwingungstilger ausgebildet sein, welcher ein Gegengewicht umfasst, mit dem der Aktor gekoppelt ist.

Diese Ausführungsform hat den Vorteil, dass die Linse zusammen mit dem aktiven Schwingungstilger ein eigenständiges aktives Schwingungsisolationssystem bildet, bei dessen Regelung der Einfluss anderer Komponenten nicht zwingend berücksichtigt werden muss.

Vorzugsweise sieht die Erfindung ein Lithographiesystem vor, bei welchem neben einem Sensor, welcher die Position oder Beschleunigung einer Linse misst, ein Referenzsensor etwa am Gehäuse der Belichtungseinheit und/oder der Basis des Schwingungsisolationssystems vorgesehen ist.

Nunmehr wird das Schwingungsisolationssystem so geregelt, dass das Signal der beiden Sensoren möglichst konstant gehalten wird, sich Linse und Gehäuse beziehungsweise Basis im Wesentlichen synchron bewegen.

Das Lithographiesystem kann einen Tisch zur schwingungsisolierten Lagerung einer Belichtungseinheit umfassen, welche eine Optik mit der Mehrzahl von positionierbaren Linsen umfasst. Weiter ist zwischen der Belichtungseinheit und dem Tisch zumindest ein Aktor zur aktiven Schwingungsisolation vorgesehen.

Insbesondere zusätzlich zu einer aktiven schwingungsisolierten Lagerung des Tisches ist die Belichtungseinheit auf Aktoren gelagert und kann relativ zur Basis ausgerichtet werden.

So können sowohl Schwingungen der gesamten Belichtungseinheit als auch Schwingungen der in der Belichtungseinheit angeordneten Linsen kompensiert werden.

Hierzu ist beispielsweise, wie es bei einer Ausführungsform der Erfindung vorgesehen ist, ein Sensor am Gehäuse der Belichtungseinheit sowie an der Basis der Belichtungseinheit vorgesehen.

Über diese Ausgestaltung wird eine Stabilisierung des Gehäuses der Belichtungseinheit erreicht, wodurch verhindert wird, dass Schwingungen von der Basis in die Belichtungseinheit propagieren und so die in der Belichtungseinheit angeordneten Linsen zu Schwingungen anregen.

Zur aktiven Schwingungsisolation sind bei einer Weiterbildung der Erfindung vorzugsweise als Schwingungstilger ausgebildete Aktoren sowohl an der Belichtungseinheit als auch an einem Tisch, auf welchem die Belichtungseinheit angeordnet ist, vorgesehen.

Der Aktor für die Belichtungseinheit greift vorzugsweise an einer Basisplatte der Belichtungseinheit an.

Das Lithographiesystem kann einen Sensor zur Erfassung von Schwingungen der Belichtungseinheit umfassen.

Ein weiterer Sensor, ein Referenzsensor, ist auf der schwingungsisoliert gelagerten Last an einer anderen Stelle, insbesondere einem schwingungsisoliert gelagerten Tisch angeordnet.

Weiter umfasst das Schwingungsisolationssystem Mittel, um die Differenz der Sensorsignale zu minimieren.

Durch diese Anordnung wird insbesondere die Prolongation von Schwingungen von außen in das System minimiert.

Die Erfindung betrifft des Weiteren ein Verfahren zur Regelung eines Lithographiesystems, insbesondere eines erfindungsgemäßen Lithographiesystems.

Gemäß des Verfahrens wird die Beschleunigung und/oder die Position einer Linse eines Belichtungssystems erfasst und basierend auf dem Sensorsignal ein mit der Linse verbundener Aktor angesteuert, um erfassten Beschleunigungen oder Positionsänderungen entgegenzuwirken beziehungsweise diese zu kompensieren.

Es versteht sich, dass unter Kompensation im Sinne der Erfindung nicht eine vollständige Kompensation jeglicher Schwingung verstanden wird, sondern dass soweit von Kompensation die Rede ist, damit jegliche Reduzierung von Schwingungen der Linse, sei es absolut gesehen oder relativ zu anderen Bauteilen gesehen, verstanden wird.

Bei einer bevorzugten Ausführungsform wird der Abstand der Linse zu einem Gehäuse, insbesondere zu dem Gehäuse einer Belichtungseinheit, im Wesentlichen konstant gehalten. Es versteht sich, dass unter konstant nicht ein Idealzustand verstanden wird, bei dem es zu keinerlei Abstandsänderungen kommt, sondern dass es auch hierbei um die Verbesserung eines gleichbleibenden Abstandes gegenüber einem System ohne Regelung geht.

Vorzugsweise wird der Abstand von mehreren Linsen, welche die Belichtungseinheit umfasst, geregelt. So wird eine Ausrichtung der Linsen zueinander erreicht, was die Strahlqualität erheblich verbessert.

Gleichzeitig wird vorzugsweise die Beschleunigung der Linse minimal gehalten.

Gemäß der Erfindung ist ein weiterer Sensor, ein Referenzsensor, vorgesehen, welcher die Beschleunigung und/oder Position der schwingungsisoliert gelagerten Last erfasst. Dieser Sensor ist also nicht vorgesehen, um Schwingungen der Linse zu erfassen, sondern außerhalb der als Feder-Masse-Schwinger betrachteten Linse angeordnet.

Der Referenzsensor erfasst also Schwingungen eines Tisches, auf welchem die Belichtungseinheit angeordnet ist.

Gemäß der Erfindung wird ein Aktor angesteuert, um die Differenz des Signals des Sensors, der die Beschleunigung und/oder Position der Linse erfasst und des Referenzsensors zu minimieren.

Die Erfindung zielt somit nicht auf eine absolute Reduzierung von Schwingungen der Linse ab, sondern führt die Linse quasi entsprechend verbleibenden Restschwingungen des Systems nach.

So werden Linse, Belichtungseinheit und letztendlich der Wafer, der mit dem Lithographiesystem belichtet wird, gegeneinander ausgerichtet, was die Auflösung des Systems verbessert.

### Kurzbeschreibung der Zeichnungen

Die Erfindung soll im Folgenden Bezug nehmend auf die Zeichnungen Fig. 1 bis Fig. 8, in welchen schematisch Lithographiesysteme und Bestandteile davon dargestellt sind, näher erläutert werden.
- Fig. 1: zeigt schematisch ein Lithographiesystem,
- Fig. 2: zeigt schematisch eine Belichtungseinheit eines Lithographiesystems nach einer Ausführungsform der Erfindung, bei welcher zwischen Linse und Gehäuse der Belichtungseinheit ein Aktor vorgesehen ist,
- Fig. 3: zeigt eine weitere Ausführungsform der Belichtungseinheit mit einem aktiven Schwingungstilger,
- Fig. 4: zeigt ein Lithographiesystem mit einem am Gehäuse der Belichtungseinheit angeordneten Referenzsensor,
- Fig. 5: zeigt ein Lithographiesystem mit einem mit der Linse gekoppelten aktiven Schwingungstilger und einem Referenzsensor auf der Basis der Belichtungseinheit,
- Fig. 6: zeigt ein Lithographiesystem, bei welchem zwei Sensoren an der Belichtungseinheit angeordnet sind, nämlich am Gehäuse und an der Basis,
- Fig. 7: zeigt eine weitere Ausführungsform eines Schwingungsisolationssystems mit Sensoren an der Belichtungseinheit,
- Fig. 8: zeigt eine weitere Ausführungsform eines Lithographiesystems, bei welchem Schwingungstilger sowohl am Tisch des Lithographiesystems als auch an der Basis des Gehäuses der Belichtungseinheit vorgesehen sind.

### Detaillierte Beschreibung der Zeichnungen

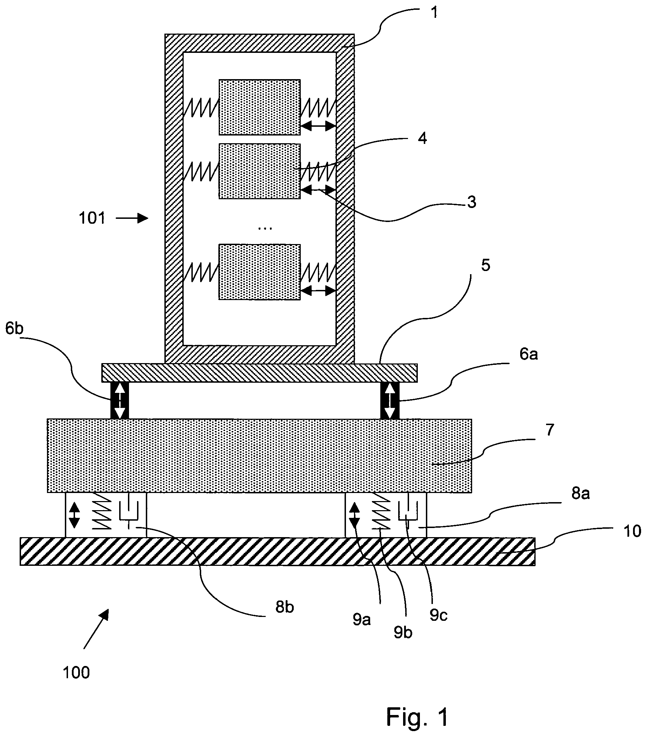

Bezugnehmend auf Fig. 1 sollen die wesentlichen Komponenten eines Lithographiesystems 100 näher erläutert werden.

Das Lithographiesystem 100 umfasst einen auch als Frame bezeichneten Tisch 7, welcher auf 2 beispielsweise als Luftlager ausgebildeten Lagern 8a, 8b schwingungsisoliert gelagert sind.

Das Lithographiesystem 100 verfügt über eine aktive Schwingungsisolation. Hierzu ist jedes Lager gleichzeitig als Aktor 9a, Feder 9b und Dämpfer 9c ausgebildet.
es versteht sich, dass sich diese Funktionen in ein Luftlager integrieren lassen, die Aufteilung in Aktor 9a, Feder 9b und Dämpfer 9c also nur als Modell für die Funktion des Lagers zu sehen ist.

Das Lithographiesystem 100 ist zur Belichtung von Wafern ausgebildet, welche über Wafer-Verfahrtische auf dem Tisch unter die Belichtungseinheit verbracht werden können (nicht dargestellt).

Weiter umfasst das Lithographiesystem 100 eine Belichtungseinheit 101, welche ein Gehäuse 1 mit einer Mehrzahl von Linsen umfasst. In diesem schematischen Ausführungsbeispiel sind nur drei Linsen 4 dargestellt. Die Belichtungseinheit umfasst im Regelfall aber bis zu 30 Linsen, welche vorzugsweise jede einzeln in eine sechs Freiheitsgraden positioniert werden können.

Vor allem aufgrund der Positioniermechanik, die Aktoren 3 umfasst, müssen die Linsen 4 als Feder-Masse-Schwinger betrachtet werden. Die Eigenfrequenz dieses Feder-Masse-Schwingers 4 liegt typischerweise zwischen 100 und 500 Hz.

Insbesondere eine Relativbewegung der Linsen 4 gegeneinander führt zu einer schlechteren Fokussierung des Strahls, wodurch die Auflösung des Lithographiesystems sinkt.

Das Gehäuse der Belichtungseinheit 1 ist auf einer Basis 5 angeordnet, welche ihrerseits über Aktoren 6a, 6b, beispielsweise Piezo-Aktoren, mit dem Tisch 7 verbunden ist. Über die Aktoren 6a und 6b kann letztendlich die Belichtungseinheit relativ zum Tisch 7 bewegt werden, wodurch beispielsweise auch eine aktive Schwingungsisolation durch eine bessere Ausrichtung von Belichtungseinheit 101 und Tisch 7 erreicht werden kann.

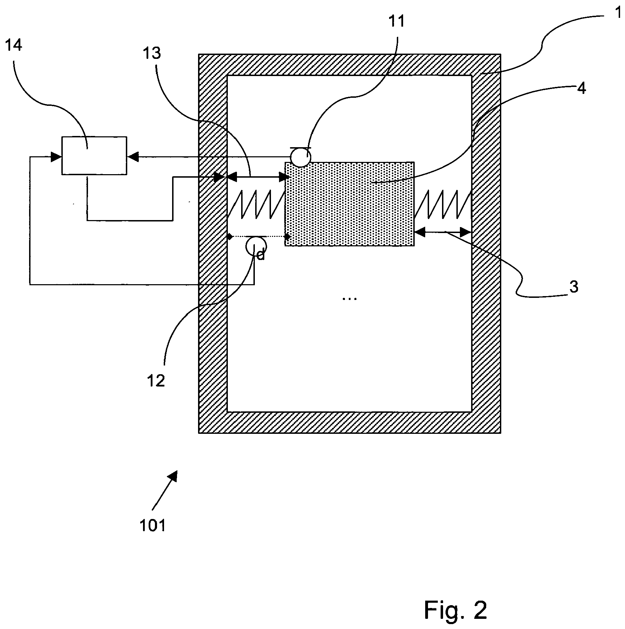

Bezugnehmend auf Fig. 2, welche nur die Belichtungseinheit 101 eines Lithographiesystems zeigt, soll eine nicht erfindungsgegenständliche Ausführungsform einer Belichtungseinheit näher erläutert werden, bei welcher eine aktive Schwingungsisolation der Linse 4 vorgesehen ist.

Die Belichtungseinheit umfasst einen an der Linse 4 angeordneten Beschleunigungssensor 11 und/oder einen Abstandssensor 12, welcher den Abstand zwischen Linse 4 und Wand des Gehäuses 1 misst. Der oder die Sensoren 11, 12 sind mit einer Regeleinrichtung 14 verbunden, über die ein Aktor 13 angesteuert wird. Der Aktor 13 ist zwischen Linse 4 und Gehäuse 1 angeordnet und sorgt für eine aktive Schwingungsisolation.

Der ohnehin für die Positionierung der Linse vorgesehene Aktor 3 kann dabei nicht verwendet werden, da hierfür die Resonanzschwingungen der Linse 4 zu hochfrequent sind.

Je nach Ausführungsform der Erfindung können Schwingungen der Linse 4 absolut minimiert werden oder, insbesondere über einen Abstandssensor 12 kann die Relativbewegung der Linse 4 zum Gehäuse 1 minimiert werden.

Es versteht sich, dass die hier dargestellte aktive Regelung vorzugsweise für eine Mehrzahl von Linsen vorgesehen ist (nicht dargestellt).

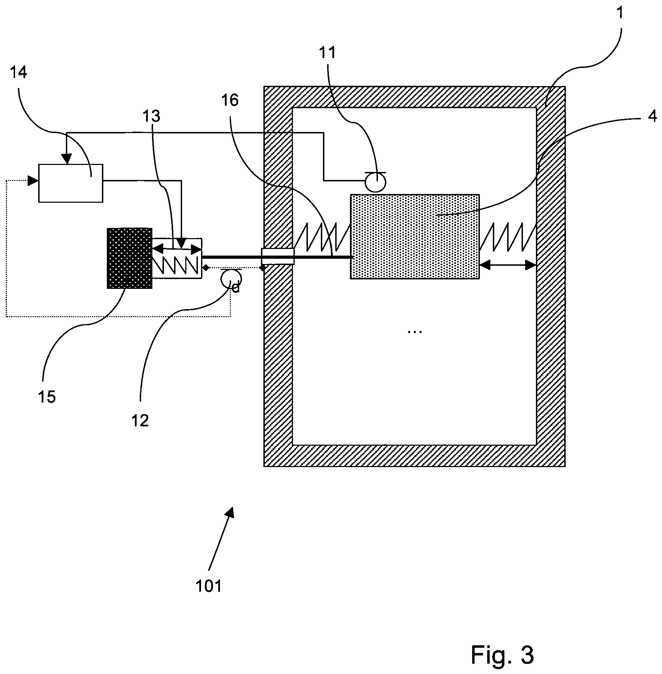

Bezugnehmend auf Fig. 3 soll eine Ausführungsform der Erfindung näher erläutert werden.

In dieser Ausführungsform ist ebenfalls ein Beschleunigungssensor 11 vorgesehen, welcher Schwingungen der Linse 4 erfasst.

Die Linse 4 ist mit einem aktiven Schwingungstilger 15 verbunden, welcher ein Gegengewicht und einen Aktor 13 umfasst.

Der aktive Schwingungstilger 15 ist vom Gehäuse 1 der Belichtungseinheit 101 abgekoppelt und über ein im Wesentlichen starres Koppelelement 16 mit der Linse verbunden. Der Schwingungstilger 15 befindet sich vorzugsweise außerhalb des Gehäuses 1 der Belichtungseinheit 101.

Alternativ oder zusätzlich zu dem an der Linse 4 angeordneten Beschleunigungssensor 1 kann auch über einen Abstandssensor 12 der Abstand des Schwingungstilgers 15 vom Gehäuse 1 der Belichtungseinheit 101 gemessen werden.

Die Sensoren 11, 12 sind mit einer Regeleinrichtung 14 verbunden, welche den Aktor 13 des Schwingungstilgers 15 ansteuert.

Es versteht sich, dass der Beschleunigungssensor 11 nicht notwendigerweise direkt auf der Linse 4 angeordnet sein muss, sondern ebenso auf starr mit der Linse verbundenen Bauteilen, wie dem Koppelelement 16 angeordnet sein kann.

Über eine Regelung über den Beschleunigungssensor 11 kann in erster Linie die Linsenbeschleunigung minimiert werden, wohingegen eine Regelung über den Abstandssensor 12 vor allem die Ausrichtung der Linse 4 relativ zum Gehäuse 1 verbessert.

Bei einer bevorzugten Ausführungsform der Erfindung sind beide Regelungen miteinander kombiniert.

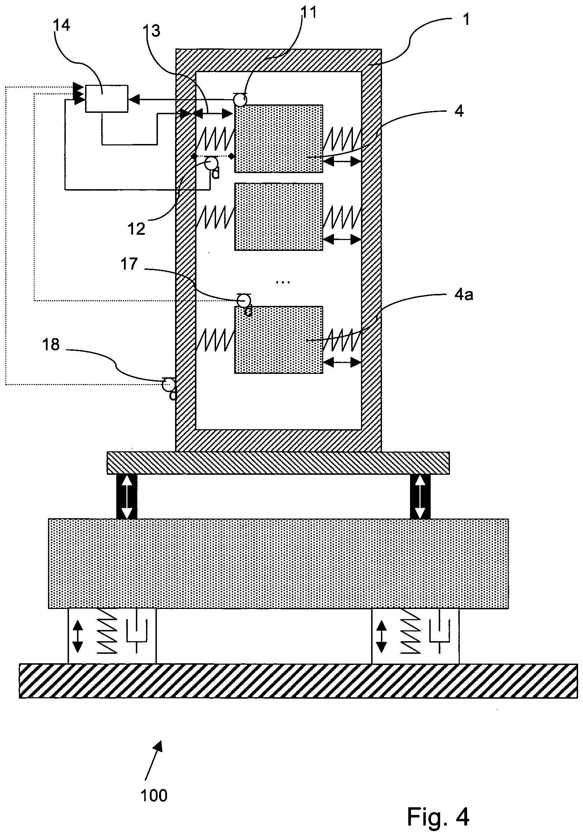

Fig. 4 zeigt schematisch eine weitere Ausführungsform eines Lithographiesystems 100. In dieser Ausführungsform ist neben dem oder den Sensoren 11, 12 einer ersten Linse 4 als Referenzsensor ein Sensor 17 auf einer weiteren Linse 4a und/oder ein Referenzsensor 18 an einer anderen Position, hier am Gehäuse 1 der Belichtungseinheit, vorgesehen.

Neben den Signalen des Sensors 11 oder 12 werden auch die Signale der Referenzsensoren 17 und/oder 18 an eine Regeleinrichtung 14 weitergeleitet.

Die Regeleinrichtung 14 steuert einen Aktor 13 an, welcher mit der Linse 4 gekoppelt ist.

Ziel der aktiven Regelung in diesem Ausführungsbeispiel ist in erster Linie die Minimierung der Differenz der Signale des Sensors 11 oder 12 mit den Referenzsensoren 17 und/oder 18.

Vorzugsweise wird eine Mehrzahl von Linsen relativ zu einem Referenzsensor geregelt. So lässt sich die Relativbewegung aller Linsen zueinander minimieren.

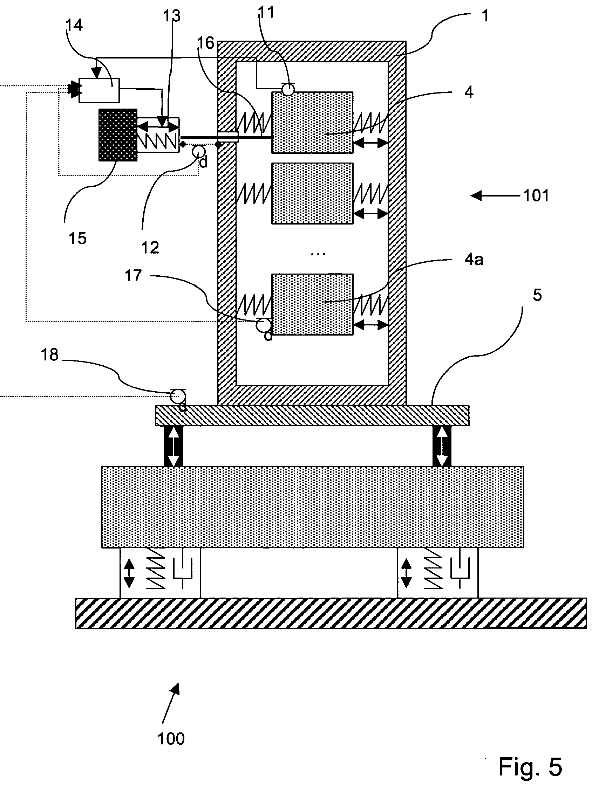

Fig. 5 zeigt eine weitere Ausführungsform eines Lithographiesystems, bei welchem ein Referenzsensor 18 vorgesehen ist, über welchen Schwingungen der Belichtungseinheit 101 erfasst werden. Ein weiterer Referenzsensor 17 erfasst Schwingungen der Linse 4a.

Schwingungen der Linse 4 werden wiederum über einen Beschleunigungs- 11 und/oder Abstandssensor 12 erfasst.

Anhand der Signale der Referenzsensoren 17 und 18, welche an eine Regelungseinheit 14 weitergeleitet werden, kann die Regelungseinheit 14 einen Aktor 13 eines aktiven Schwingungstilgers 15 ansteuern. Hierdurch wird eine verbesserte Ausrichtung der Linsen zueinander erreicht.

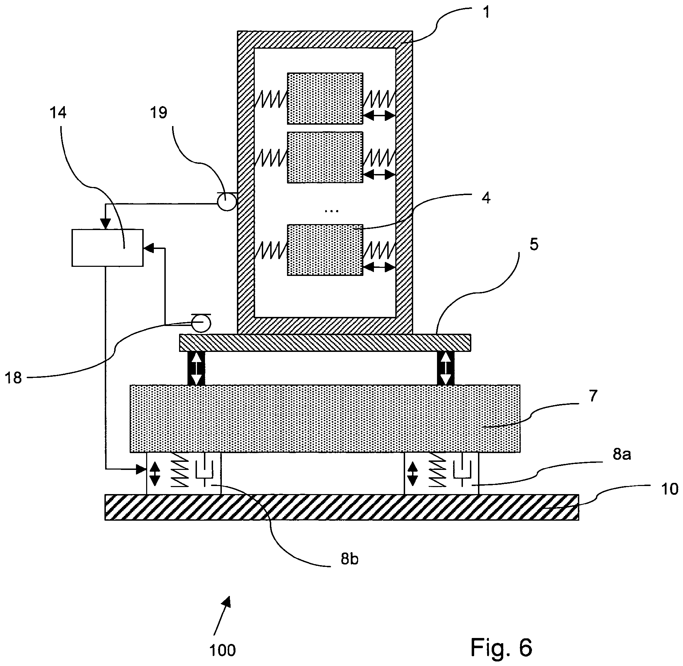

Fig. 6 zeigt eine Ausführungsform gemäß der vor allem die Propagation von Schwingungen des Bodens 10 zu den Linsen 4 reduziert werden soll.

Hierzu ist ein Sensor 19 am Gehäuse 1 der Belichtungseinheit vorgesehen. Ein weiterer Sensor 18 ist an der Basis 5 der Belichtungseinheit vorgesehen.

Die Signale beider Sensoren 18, 19 werden an eine Regeleinrichtung 14 weitergeleitet, welche die aktiven Lager 8a, 8b des Tisches ansteuert.

Durch diese Regelung werden vor allem Schwingungen auf dem Weg zum Gehäuse 1 minimiert, welche ihrerseits Schwingungen der Linse 4 verursachen.

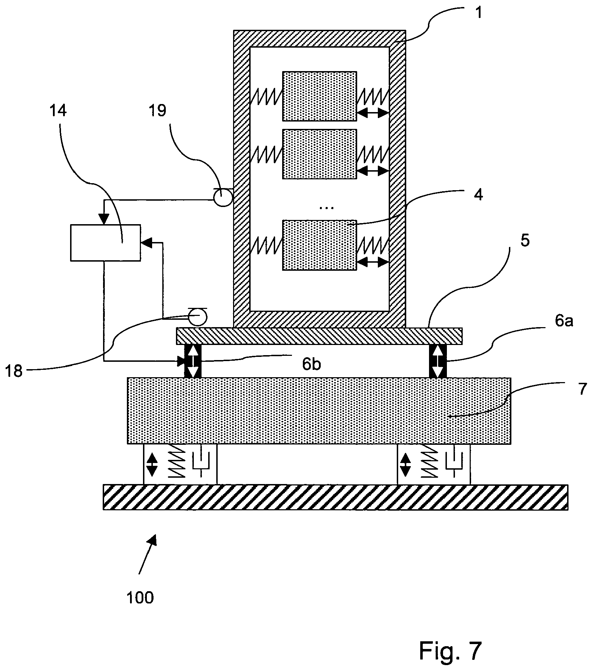

Fig. 7 zeigt eine weitere Ausführungsform, welche im Wesentlichen der in Fig. 6 dargestellten Ausführungsform entspricht, wobei hier zusätzlich oder alternativ von der Regeleinrichtung 14 die zwischen der Belichtungseinheit und dem Tisch angeordneten Aktoren 6a, 6b angesteuert werden.

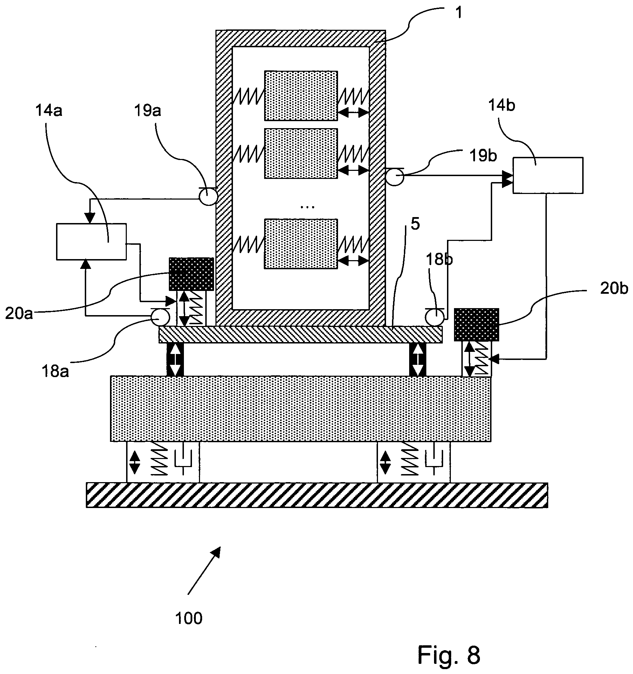

Fig. 8 zeigt eine weitere Ausführungsform eines Lithographiesystems 100, bei welchem Sensoren 18a, 18b an der Basis 5 der Belichtungseinheit sowie Sensoren 19a, 19b am Gehäuse 1 der Belichtungseinheit vorgesehen sind.

Basierend auf den Signalen der Sensoren wird ein aktiver Schwingungstilger 20a, welcher an der Belichtungseinheit angreift, sowie ein aktiver Schwingungstilger 20b, welcher am Tisch angreift, angesteuert.

Diese Ausführungsform der Erfindung dient ebenfalls in erster Linie der Reduzierung der Propagation von Schwingungen in Richtung des Gehäuses 1 der Belichtungseinheit.

Es bietet sich an, die in den Figuren 6 bis 7 dargestellte aktive Schwingungsisolation mit der in der Fig. 1 bis 5 dargestellten Regelung zu verknüpfen.

### Bezugszeichenliste

- 1: Gehäuse
- 3: Aktor
- 4: Linse
- 5: Basis
- 6a, 6b: Piezoaktor
- 7: Tisch
- 8a, 8b: Lager
- 9a: Aktor
- 9b: Feder
- 9c: Dämpfer
- 10: Boden
- 11: Sensor
- 12: Sensor
- 13: Aktor
- 14: Regeleinrichtung
- 15: Schwingungstilger
- 16: Koppelelement
- 17: Referenzsensor
- 18: Referenzsensor
- 19: Sensor
- 20a, 20b: Schwingungstilger
- 100: Lithographiesystem
- 101: Belichtungseinheit

Schwingungen der Linse 4 werden wiederum über einen Beschleunigungs- 11 und/oder Abstandssensor 12 erfasst.

Anhand der Signale der Referenzsensoren 17 und 18, welche an eine Regelungseinheit 14 weitergeleitet werden, kann die Regelungseinheit 14 einen Aktor 13 eines aktiven Schwingungstilgers 15 ansteuern. Hierdurch wird eine verbesserte Ausrichtung der Linsen zueinander erreicht.

Fig. 6 zeigt eine Ausführungsform der Erfindung gemäß der vor allem die Propagation von Schwingungen des Bodens 10 zu den Linsen 4 reduziert werden soll.

Hierzu ist ein Sensor 19 am Gehäuse 1 der Belichtungseinheit vorgesehen. Ein weiterer Sensor 18 ist an der Basis 5 der Belichtungseinheit vorgesehen.

Die Signale beider Sensoren 18, 19 werden an eine Regeleinrichtung 14 weitergeleitet, welche die aktiven Lager 8a, 8b des Tisches ansteuert.

Durch diese Regelung werden vor allem Schwingungen auf dem Weg zum Gehäuse 1 minimiert, welche ihrerseits Schwingungen der Linse 4 verursachen.

Fig. 7 zeigt eine weitere Ausführungsform der Erfindung, welche im Wesentlichen der in Fig. 6 dargestellten Ausführungsform entspricht, wobei hier zusätzlich oder alternativ von der Regeleinrichtung 14 die zwischen der Belichtungseinheit und dem Tisch angeordneten Aktoren 6a, 6b angesteuert werden.

Fig. 8 zeigt eine weitere Ausführungsform eines Lithographiesystems 100, bei welchem Sensoren 18a, 18b an der Basis 5 der Belichtungseinheit sowie Sensoren 19a, 19b am Gehäuse 1 der Belichtungseinheit vorgesehen sind.

Basierend auf den Signalen der Sensoren wird ein aktiver Schwingungstilger 20a, welcher an der Belichtungseinheit angreift, sowie ein aktiver Schwingungstilger 20b, welcher am Tisch angreift, angesteuert.

Diese Ausführungsform der Erfindung dient ebenfalls in erster Linie der Reduzierung der Propagation von Schwingungen in Richtung des Gehäuses 1 der Belichtungseinheit.

Es bietet sich an, die in den Figuren 6 bis 7 dargestellte aktive Schwingungsisolation mit der in der Fig. 1 bis 5 dargestellten Regelung zu verknüpfen.

Es versteht sich ferner, dass die Erfindung nicht auf eine Kombination der in den Ausführungsbeispielen beschriebenen Merkmalen beschränkt ist, sondern dass der Fachmann sämtliche Merkmale, soweit es technisch sinnvoll ist, kombinieren wird.

### Bezugszeichenliste

- 1: Gehäuse
- 3: Aktor
- 4: Linse
- 5: Basis
- 6a, 6b: Piezoaktor
- 7: Tisch
- 8a, 8b: Lager
- 9a: Aktor
- 9b: Feder
- 9c: Dämpfer
- 10: Boden
- 11: Sensor
- 12: Sensor
- 13: Aktor
- 14: Regeleinrichtung
- 15: Schwingungstilger
- 16: Koppelelement
- 17: Referenzsensor
- 18: Referenzsensor
- 19: Sensor
- 20a, 20b: Schwingungstilger
- 100: Lithographiesystem
- 101: Belichtungseinheit

## Patentansprüche

1. Lithographiesystem (100), insbesondere zur Belichtung von Halbleiterwafern, umfassend eine schwingungsisoliert gelagerte Belichtungseinheit (101), wobei die Belichtungseinheit (101) eine Optik mit einer Mehrzahl von positionierbaren Linsen (4) umfasst,
wobei durch jeweils einen einer Linse (4) zugeordneten Sensor (11) die Position und/oder Beschleunigung der Linsen (4) erfasst wird,
**dadurch gekennzeichnet, dass** die Linsen (4) jeweils über einen von einem Gehäuse der Optik entkoppelten Aktor (13) aktiv schwingungsisoliert sind.

2. Lithographiesystem nach Anspruch 1, **dadurch gekennzeichnet, dass** der Aktor (13) außerhalb eines Gehäuses der Belichtungseinheit angeordnet und mit zumindest einer Linse (4) verbunden ist.

3. Lithographiesystem nach dem vorstehenden Anspruch,
**dadurch gekennzeichnet, dass** das Lithographiesystem (100) Mittel zum Einstellen des Abstandes zumindest einer Linse (4) relativ zu einem Gehäuse der Belichtungseinheit (101) aufweist.

4. Lithographiesystem nach einem der vorstehenden Ansprüche, **dadurch gekennzeichnet, dass** am Gehäuse (1) der Belichtungseinheit (101) der Sensor (11) zur Erfassung der Position und/oder Beschleunigung angeordnet ist.

5. Lithographiesystem nach einem der vorstehenden Ansprüche, **dadurch gekennzeichnet, dass** zumindest ein Aktor zur aktiven Schwingungsisolation (20a) am Tisch angreift.

6. Lithographiesystem (100) nach einem der vorstehenden Ansprüche, weiter umfassend einen schwingungsisoliert gelagerten Tisch (7), auf dem die Belichtungseinheit (101) ruht, und wobei das Lithographiesystem (100) einen Sensor (19) zur Erfassung von Schwingungen einer Belichtungseinheit (101),
zumindest einen Referenzsensor (18), der an einemschwingungsisoliert gelagerten Tisch (7) angeordnet ist zur Erfassung der Beschleunigung und/oder der Position des Tisches (7), sowie Mittel um die Differenz zwischen den Sensorsignalen zu minimieren, aufweist.

7. Verfahren zur Regelung eines Lithographiesystems, umfassend die Schritte:
- Erfassen der Beschleunigung und/oder der Position einer Linse (4) einer Belichtungseinheit (101) mittels zumindest eines Sensors (11);
- Erfassen der Beschleunigung und/oder der Position eines schwingungsisoliert gelagerten Tisches, auf dem die Belichtungseinheit (101) ruht, mittels eines Referenzsensors (18);
- Ansteuern eines Aktors zur Minimierung einer Differenz der Signale des Sensors und des Referenzsensors, wobei die Linse (4) entsprechend den verbleibenden Restschwingungen des Systems nachgefahren wird.

8. Verfahren zur Regelung eines Lithographiesystems (100), nach Anspruch 7, **dadurch gekennzeichnet, dass** Beschleunigung und/oder der Position einer weiteren Linse (4) mittels eines weiteren Sensors (18, 11) erfasst wird und
ein Aktor zur Minimierung einer Differenz der Signale des Sensors (19) und des weiteren Sensors (18, 11) angesteuert wird.

9. Verfahren zur Regelung eines Lithographiesystems nach dem vorstehenden Anspruch, **dadurch gekennzeichnet, dass** ein Aktor an einem schwingungsisoliert gelagerten Tisch (7), auf dem die Belichtungseinheit (101) angeordnet ist, angreift.

## Claims

1. Lithography system (100), in particular for the exposure of semiconductor wafers, comprising an exposure unit (101) mounted in a vibration-isolated manner, wherein the exposure unit (101) comprises optics with a plurality of lenses (4) that can be positioned,
wherein, by a sensor each dedicated to a lens (4), the position and/or the acceleration of the lenses (4) is detected,
**characterized in that** the lenses are each actively vibration-isolated via one actuator (13) which decoupled from a housing of the optics.

2. Lithography system according to claim 1, **characterized in that** the actuator (13) is located outside a housing of the exposure unit and is connected with at least one lens (4).

3. Lithography system according to the preceding claim, **characterized in that** the lithography system (100) has means to adjust the distance of a lens relative a housing (1) of the exposure unit (101).

4. Lithography system according to one of the preceding claims, **characterized in** the sensor (11) to detect the position and/or the acceleration is located on a housing (1) of the exposure unit (101).

5. Lithography system according to one of the preceding claims, **characterized in that** at least one actuator for active vibration isolation (20a) acts on the table.

6. Lithography system (100) according to one of the preceding claims, further comprising a vibration isolated table (7), on which the exposure unit rests, and wherein the lithography system (100) comprises a sensor (19) to detect vibrations of an exposure unit, at least one reference sensor (18) which is located on a vibration-isolated table, and means to minimize the difference between the sensor signals.

7. Process for the control of a lithography system, in particular a lithography system according to one of the preceding claims, comprising the steps:
- detection of the acceleration and/or position of a lens (4) of an exposure unit (101) by means of at least one sensor (11);
- detection of the acceleration and/or position of a vibration-insulated table on which die exposure unit (101) rests, by means of a reference sensor (18);
- control of an actuator to minimize a difference between the signals of the sensor and the reference sensor, wherein the lens (4) is readjusted in accordance with the remaining residual vibrations of the system.

8. Process for the control of a lithography system (100) according to claim 7, **characterized in that** the acceleration and/or position of another lens (4) is detected by means of another sensor (11,18), and wherein an actuator is controlled to minimize a difference between the signals of the sensor (19) and the other sensor (11,18).

9. Process for the control of a lithography system according to the preceding claim, **characterized in that** an actuator acts on a table (7), mounted in a vibration-isolated manner, on which the exposure unit (101) is located.

## Revendications

1. Système de lithographie (100), destiné en particulier à exposer des tranches semi-conductrices, comprenant une unité d'exposition (101) montée de manière à être isolée des vibrations, l'unité d'exposition (101) comprenant une optique présentant une pluralité de lentilles (4) positionnables,
la position et/ou l'accélération des lentilles (4) étant détectées par respectivement un capteur (11) associé à une lentille (4),
**caractérisé en ce que** les lentilles (4) sont chacune isolées activement des vibrations au moyen d'un actionneur (13) découplé d'un boîtier de l'optique.

2. Système de lithographie selon la revendication 1, **caractérisé en ce que** l'actionneur (13) est agencé à l'extérieur d'un boîtier de l'unité d'exposition et relié à au moins une lentille (4).

3. Système de lithographie selon l'une quelconque des revendications précédentes, le système de lithographie (100) étant **caractérisé en ce qu'**il comprend des moyens permettant de régler l'écart entre au moins une lentille (4) et un boîtier de l'unité d'exposition (101).

4. Système de lithographie selon l'une quelconque des revendications précédentes, **caractérisé en ce que** le capteur (11) destiné à détecter la position et/ou l'accélération est agencé sur le boîtier (1) de l'unité d'exposition (101).

5. Système de lithographie selon l'une quelconque des revendications précédentes, **caractérisé en ce qu'**au moins un actionneur permettant l'isolation active des vibrations (20a) agit sur la table.

6. Système de lithographie (100) selon l'une quelconque des revendications précédentes, comprenant en outre une table (7) montée de manière à être isolée des vibrations, sur laquelle l'unité d'exposition (101) repose, et le système de lithographie (100) comprenant un capteur (19) destiné à détecter les vibrations d'une unité d'exposition (101),
au moins un capteur de référence (18), qui est agencé sur une table (7) montée de manière à être isolée des vibrations, pour détecter l'accélération et/ou la position de la table (7), ainsi que des moyens permettant de réduire au minimum la différence entre les signaux de capteur.

7. Procédé de commande d'un système de lithographie, comprenant les étapes consistant à :
- détecter l'accélération et/ou la position d'une lentille (4) d'une unité d'exposition (101) au moyen d'au moins un capteur (11) ;
- détecter l'accélération et/ou la position d'une table montée de manière à être isolée des vibrations, sur laquelle l'unité d'exposition (101) repose, au moyen d'un capteur de référence (18) ;
- commander un actionneur pour réduire au minimum une différence entre les signaux du capteur et ceux du capteur de référence, la lentille (4) étant guidée en fonction des vibrations résiduelles restantes du système.

8. Procédé de commande d'un système de lithographie (100), selon la revendication 7, **caractérisé en ce que** l'accélération et/ou la position d'une autre lentille (4) sont détectées au moyen d'un autre capteur (18, 11), et
un actionneur est commandé pour réduire au minimum une différence entre les signaux du capteur (19) et ceux de l'autre capteur (18, 11).

9. Procédé de commande d'un système de lithographie selon l'une quelconque des revendications précédentes, **caractérisé en ce qu'**un actionneur agit sur une table (7) montée de manière à être isolée des vibrations sur laquelle repose l'unité d'exposition (101).
